# DEMANDE DE BREVET EUROPEEN

(11) **EP 3 450 251 A1**
(43) Date de publication de la demande: **06.03.2019**
(21) Numéro de dépôt: 18187041.1
(22) Date de dépôt: 02.08.2018
(51) Int. Cl.: B60Q 1/00

(54) **DISPOSITIF LUMINEUX POUR VEHICULE AUTOMOBILE**

(30) Priorité: 31.08.2017 FR 1758031
(71) Demandeur: Valeo Vision, 93012 Bobigny Cedex (FR)
(72) Inventeur: PAUGAM, Stéphane, 49000 ANGERS (FR); CESAIRE, Julien, 49000 ANGERS (FR); MILARET, Benoit, 49000 ANGERS (FR); NODET, Gilles, 49000 ANGERS (FR); BLOT, Remi, 49000 ANGERS (FR); BEDOYA, Carlos, 49000 ANGERS (FR)
(74) Mandataire: Valeo Vision

(57) **Abrégé**

L'invention concerne un dispositif lumineux (1) pour véhicule automobile, ledit dispositif lumineux (1) comprenant :
- un boîtier (10) ;
- un module lumineux disposé à l'intérieur dudit boîtier (10) ;
- un dispositif de pilotage (12) adapté pour piloter l'alimentation électrique dudit module lumineux (11) comportant un connecteur femelle (120) monté à l'extérieur dudit boîtier (10) ;
- un faisceau de connexion (13) relié audit module lumineux (11) et comportant un connecteur mâle (130) adapté pour être connecté audit connecteur femelle (120) dudit dispositif de pilotage (12) de sorte à relier électriquement ledit dispositif de pilotage (12) audit module lumineux (11),
caractérisé en ce que ledit boîtier comporte :
- un orifice (100) pour le passage dudit faisceau de connexion (13) depuis l'intérieur vers l'extérieur dudit boîtier (10) ; et
- au moins deux nervures (101, 104) définissant un logement (103) pour accueillir et bloquer ledit connecteur mâle (130) sur ledit boîtier (10).

## Description

### DOMAINE TECHNIQUE DE L'INVENTION

La présente invention concerne un dispositif lumineux pour véhicule automobile.

Elle trouve une application particulière dans les projecteurs pour véhicule automobile.

### ARRIÈRE-PLAN TECHNOLOGIQUE DE L'INVENTION

Un dispositif lumineux pour véhicule automobile comprend de manière connue de l'homme du métier :
- un boîtier ;
- un module lumineux disposé à l'intérieur dudit boîtier ;
- un dispositif de pilotage de l'alimentation électrique du module lumineux comportant un connecteur femelle monté à l'extérieur dudit boîtier ;
- un faisceau de connexion relié audit module lumineux et comportant un connecteur mâle adapté pour être connecté audit connecteur femelle dudit dispositif de pilotage de sorte à relier électriquement ledit dispositif de pilotage audit module lumineux.

Le dispositif de pilotage est assemblé dans le boîtier du dispositif lumineux manuellement par un opérateur.

Un inconvénient de cet état de la technique est que l'assemblage est compliqué car l'opérateur doit plaquer le dispositif de pilotage dans le boîtier depuis l'extérieur avec une main, maintenir le faisceau de connexion à l'intérieur du boîtier avec l'autre main et visser le dispositif de pilotage sur le boîtier en même temps. Il n'est pas possible de préfixer le dispositif de pilotage, car ce dernier doit pouvoir être changé et ne peut donc pas être fixé à demeure.

Dans ce contexte, la présente invention vise à résoudre l'inconvénient précédemment mentionné.

### DESCRIPTION GENERALE DE L'INVENTION

A cette fin l'invention propose un dispositif lumineux pour véhicule automobile, ledit dispositif lumineux comprenant :
- un boîtier ;
- un module lumineux disposé à l'intérieur dudit boîtier ;
- un dispositif de pilotage adapté pour piloter l'alimentation électrique dudit module lumineux comportant un connecteur femelle monté à l'extérieur dudit boîtier ;
- un faisceau de connexion relié audit module lumineux et comportant un connecteur mâle adapté pour être connecté audit connecteur femelle dudit dispositif de pilotage de sorte à relier électriquement ledit dispositif de pilotage audit module lumineux,
caractérisé en ce que ledit boîtier comporte :
- un orifice pour le passage dudit faisceau de connexion depuis l'intérieur vers l'extérieur dudit boîtier ; et
- au moins deux nervures définissant un logement pour accueillir et bloquer ledit connecteur mâle sur ledit boîtier.

Ainsi, comme on va le voir en détail ci-après, l'invention évite à l'opérateur de maintenir le faisceau de connexion avec une de ses mains. Le faisceau de connexion tient tout seul. On supprime ainsi un des gestes d'assemblage. Les mains de l'opérateur sont ainsi libérées pour effectuer l'assemblage du dispositif de pilotage dans le boîtier. Ainsi, cela permet, d'une part de gagner du temps lors de l'assemblage et donc d'augmenter la productivité, et d'autre part d'améliorer l'ergonomie pour l'opérateur. L'opérateur ne prend plus de mauvaises postures.

Selon des modes de réalisation non limitatifs, le dispositif lumineux peut comporter en outre une ou plusieurs caractéristiques supplémentaires parmi les suivantes :
Selon un mode de réalisation non limitatif, lesdites au moins deux nervures s'étendent dans ledit orifice et définissent un sous-orifice pour le passage dudit faisceau de connexion une fois ledit connecteur mâle bloqué dans le logement.

Selon un mode de réalisation non limitatif, ledit sous-orifice est de largeur sensiblement égale ou inférieure à la largeur dudit faisceau de connexion.

Selon un mode de réalisation non limitatif, lesdites au moins deux nervures s'étendent de part et d'autre dudit orifice en définissant un espace entre elles pour permettre le passage du faisceau de connexion depuis l'intérieur dudit boîtier lors de montage dudit connecteur mâle sur ledit boîtier.

Selon un mode de réalisation non limitatif, ledit boîtier comprend un réseau de nervures, en retrait dudit orifice, adapté pour définir avec lesdites au moins deux nervures dans l'orifice ledit logement de réception dudit connecteur mâle.

Selon un mode de réalisation non limitatif, ledit réseau de nervures comprend :
- des nervures primaires définissant ledit logement ;
- au moins une nervure secondaire adaptée pour solidariser le reste du réseau de nervures au boîtier.

Selon un mode de réalisation non limitatif, lesdites nervures primaires sont orientées dans différentes directions de sorte à bloquer ledit connecteur mâle dans lesdites directions.

Selon un mode de réalisation non limitatif, chaque nervure primaire comprend un profil en escalier avec :
- une pente oblique pour forcer le centrage dudit connecteur mâle dans ledit logement ;
- un ressaut pour bloquer en butée ledit connecteur mâle ;
- un plateau servant d'appui pour ledit connecteur mâle sur ledit boîtier.

Selon un mode de réalisation non limitatif, ledit boîtier comprend en outre au moins un clip de maintien adapté pour maintenir le faisceau de connexion en position.

Selon un mode de réalisation non limitatif, ledit dispositif de pilotage est plaqué sur ledit boîtier pour connecter ledit connecteur femelle audit connecteur mâle.

Selon un mode de réalisation non limitatif, une source lumineuse est une source lumineuse à semi-conducteur.

Selon un mode de réalisation non limitatif, ladite source lumineuse à semi-conducteur fait partie d'une diode électroluminescente.

Selon un mode de réalisation non limitatif, ledit dispositif lumineux est un projecteur.

Selon un mode de réalisation non limitatif, ledit boîtier comprend une partie d'accueil du dispositif de pilotage, ladite partie d'accueil comprenant ledit orifice pour le passage dudit faisceau de connexion, et lesdites au moins deux nervures définissant ledit logement pour accueillir et bloquer ledit connecteur mâle sur ledit boîtier.

### BREVE DESCRIPTION DES FIGURES

L'invention et ses différentes applications seront mieux comprises à la lecture de la description qui suit et à l'examen des figures qui l'accompagnent.
- la figure 1 représente un dispositif lumineux selon un mode de réalisation non limitatif de l'invention, ledit dispositif lumineux comprenant un boîtier et un dispositif de pilotage ;
- la figure 2 représente une vue en perspective éclatée d'une partie du boîtier du dispositif lumineux et du dispositif de pilotage de la figure 1, selon un mode de réalisation non limitatif ;
- la figure 3 représente une vue de côté et en en perspective de la partie du boîtier dans laquelle est monté le dispositif de pilotage de la figure 2, selon un mode de réalisation non limitatif ;
- la figure 4a représente une vue de dessus de l'intérieur de la partie du boîtier de la figure 2, selon un mode de réalisation non limitatif ;
- la figure 4b représente la partie du boîtier de la figure 3 coopérant avec un connecteur mâle, selon un premier mode de réalisation non limitatif ;
- la figure 5a représente une vue de dessous de la partie du boîtier de la figure 3, selon un mode de réalisation non limitatif ;
- la figure 5b représente un faisceau de connexion sortant du boîtier de la figure 3, selon un mode de réalisation non limitatif ;
- la figure 6 représente une vue en coupe de la partie du boîtier selon l'axe A-A de la figure 4A, ladite partie du boîtier comprenant au moins une nervure ;
- la figure 7 représente une vue en zoom de profil de la nervure de la partie du boîtier de la figure 6 ;
- la figure 8 représente une vue de dessus de la partie du boîtier de la figure 3 coopérant avec un connecteur mâle, selon un deuxième mode de réalisation non limitatif ;
- la figure 9 représente une vue en perspective de la partie du boîtier de la figure 8.

### DESCRIPTION DE MODES DE REALISATION DE L'INVENTION

Les éléments identiques, par structure ou par fonction, apparaissant sur différentes figures conservent, sauf précision contraire, les mêmes références.

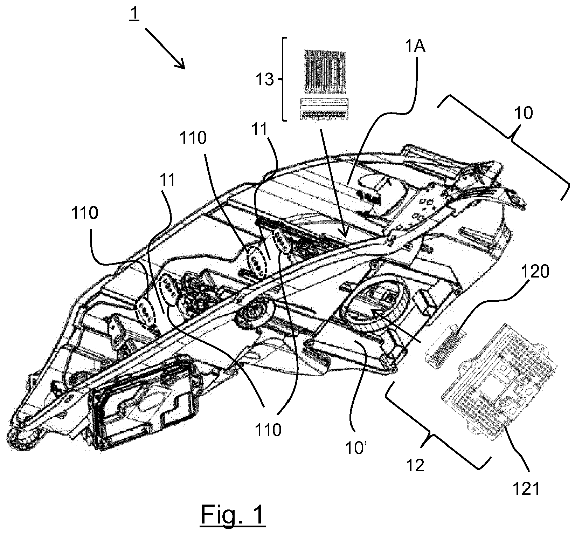

Le dispositif lumineux 1 pour véhicule automobile selon l'invention est décrit en référence aux figures 1 à 9.

Par véhicule automobile, on entend tout type de véhicule motorisé.

Dans un mode de réalisation non limitatif, le dispositif lumineux 1 est un dispositif d'éclairage et/ou signalisation. Dans une variante de réalisation non limitative, le dispositif d'éclairage et/ou signalisation est un projecteur pour véhicule automobile.

Le dispositif lumineux 1 est adapté pour assurer une fonction photométrique déterminée. Dans des modes de réalisation non limitatifs, la fonction photométrique est :
- une fonction photométrique dite « high beam » pour réaliser un feu de route ; et/ou
- une fonction photométrique dite « low beam » pour réaliser, par exemple, un feu de croisement.

Dans un mode de réalisation non limitatif illustré sur la figure 1, le dispositif lumineux 1 comprend :
- un boîtier 10 ;
- un module lumineux 11 ;
- un dispositif de pilotage 12 adapté pour piloter l'alimentation électrique du module lumineux 11 ;
- un faisceau de connexion 13 relié audit module lumineux 11.

Dans l'exemple non limitatif illustré sur la figure 1, le dispositif lumineux 1 comprend deux modules lumineux 11.

Les éléments du dispositif lumineux 1 sont décrits en détail ci-dessous.

### • Module lumineux 11

Le module lumineux 11 est illustré à la figure 1.

Le module lumineux 11 est disposé à l'intérieur du boîtier 10.

Il est adapté pour produire un faisceau lumineux.

Ledit module lumineux 11 comprend :
- au moins une source lumineuse 110 adaptée pour produire des rayons lumineux ;
- un module optique (non illustré) adapté pour coopérer avec lesdits rayons lumineux de ladite au moins une source lumineuse 110 de sorte à produire le faisceau lumineux.

Dans un mode de réalisation non limitatif, la source lumineuse est une source lumineuse à semi-conducteur.

Dans un mode de réalisation non limitatif, la source lumineuse à semi-conducteur fait partie d'une diode électroluminescente.

Par diode électroluminescente, on entend tout type de diodes électroluminescentes, que ce soit dans des exemples non limitatifs des LED (« Light Emitting Diode »), une OLED (« Organic LED ») ou une AMOLED (« Active-Matrix-Organic LED »), ou encore une FOLED (« Flexible OLED »). Dans un mode de réalisation non limitatif, le module optique comprend un réflecteur et/ou une lentille et/ou un guide de lumière.

### • Dispositif de pilotage 12

Le dispositif de pilotage 12 est illustré sur les figures 1 à 3.

Il est adapté pour piloter l'alimentation électrique du module lumineux 11, en particulier de ses sources lumineuses 110.

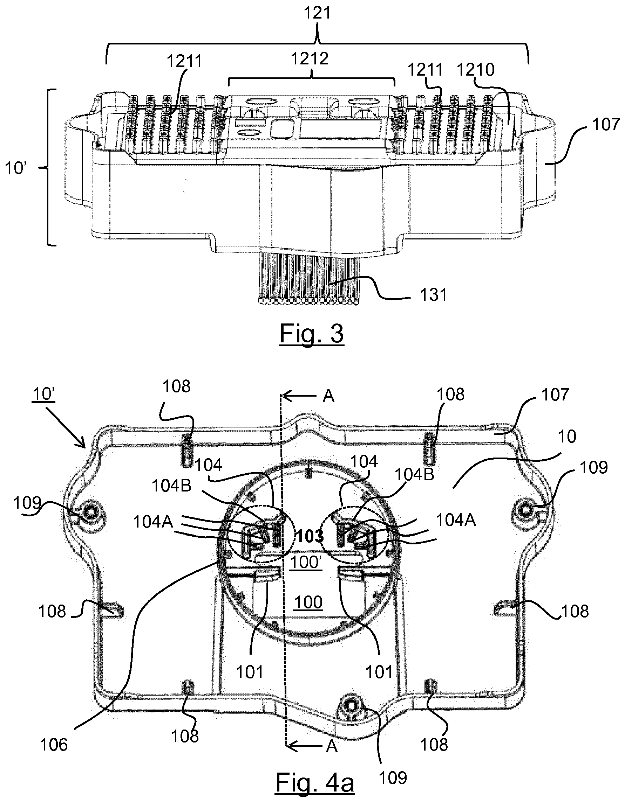

Tel qu'illustré sur la figure 3, il est adapté pour se loger dans une partie 10' du boîtier 10 du dispositif lumineux 1.

Le dispositif de pilotage 12 comprend :
- un composant électronique de pilotage (non illustré sur les figures) ;
- un connecteur femelle 120 monté à l'extérieur du boîtier 10 ;
- un dissipateur thermique 121 qui fait également office de boîtier de protection.

### ∘ Composant électronique de pilotage

Dans un mode de réalisation non limitatif, le composant électronique de pilotage est un convertisseur DC/DC. Dans un autre mode de réalisation non limitatif, le composant électronique de pilotage comprend un ou plusieurs transistors. Dans un exemple non limitatif, le transistor est un MOSFET. Le composant électronique de pilotage est disposé sur un support électronique logé entièrement dans le dissipateur thermique 121. Dans un mode de réalisation non limitatif, le support électronique est une carte à circuit imprimé PCBA (« Printed Circuit Board Assembly » en anglais). Le support électronique comprend une pluralité de composants électroniques, dont le composant électronique de pilotage. Ces composants électroniques génèrent de la chaleur au cours de leur fonctionnement. Cette chaleur est évacuée hors du dispositif de pilotage 12 par le dissipateur thermique 121.

### ∘ Connecteur femelle 120

Le connecteur femelle 120 est adapté pour relier électriquement le dispositif de pilotage 12 au module lumineux 11. Ce connecteur femelle 120 est adapté pour coopérer avec un connecteur mâle 130 du faisceau de connexion 13.

### ∘ Dissipateur thermique 121

Le dissipateur thermique 121 est illustré sur les figures 1 à 3.

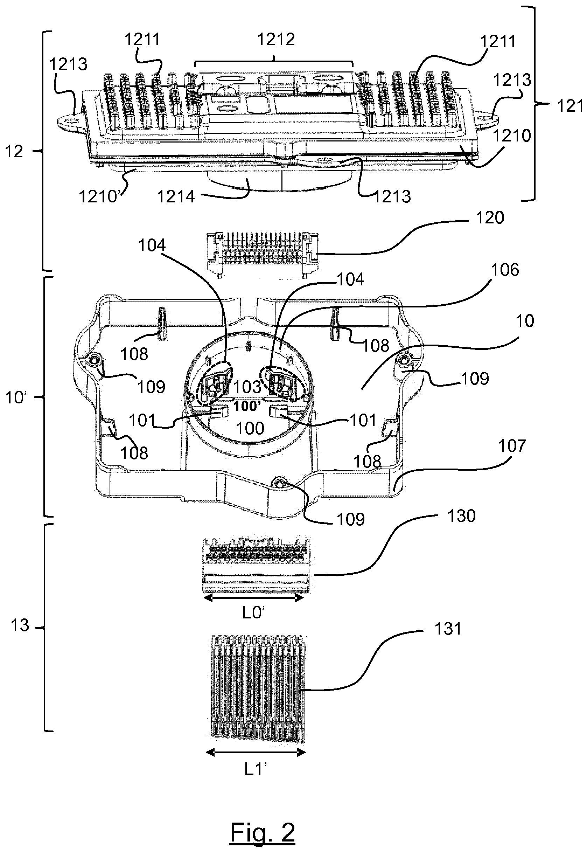

Il est adapté pour dissiper la chaleur dégagée par le dispositif de pilotage 12. Le dissipateur thermique 121 forme un boîtier. Il renferme le support électronique (non illustré) sur lequel est disposé notamment le composant électronique de pilotage. Il protège ainsi le support électronique et ses composants électroniques contre les poussières et les infiltrations de liquide tel que de l'eau. A cet effet, le dissipateur thermique 121 comporte une partie 1212 conformée en fonction des composants électroniques du dispositif de pilotage 12 tel qu'illustré sur les figures 2 et 3.

Dans un mode de réalisation non limitatif, le dissipateur thermique 121 est en aluminium. C'est un matériau léger, peu coûteux et bon dissipateur de chaleur. Dans un autre mode de réalisation non limitatif, le dissipateur thermique 121 est réalisé dans un matériau thermoplastique adapté pour dissiper la chaleur.

Tel qu'illustré sur la figure 2, le dissipateur thermique 121 comprend :
- un corps de base 1210 ;
- un capot 1210' ;
- au moins un ergot de fixation 1213 ;
- une collerette d'étanchéité primaire 1214.

Dans un mode de réalisation non limitatif, le dissipateur thermique 121 comprend en outre des protubérances 1211.

Le capot 1210' coopère avec le corps de base 1210 de sorte à former le boîtier du dissipateur thermique 121.

Des ergots de fixation 1213 permettent le passage de moyens de fixation, tels que des tiges filetées ou des vis, pour la fixation du dissipateur thermique 121 sur ladite partie 10' du boîtier 10.

Les protubérances 1211 permettent d'augmenter la surface d'échange thermique avec un flux d'air. Dans le mode de réalisation non limitatif illustré sur les figures 1 à 3, les protubérances 1211 sont des picots. Dans un autre mode de réalisation non limitatif, les protubérances 1211 sont des ailettes. Dans un mode de réalisation non limitatif, les protubérances 1211 sont disposées sur un côté du corps de base 1210 opposé à celui sur lequel est disposée la collerette d'étanchéité primaire 1214.

Tel qu'illustré sur la figure 2, la collerette d'étanchéité primaire 1214 s'étend à partir du capot 1210'. Elle est adaptée pour s'insérer dans une collerette d'étanchéité secondaire 106 du boîtier 10.

### • Faisceau de connexion 13

Le faisceau de connexion 13 est illustré sur la figure 2.

Le faisceau de connexion 13 est adapté pour être relié au module lumineux 11. Il est ainsi adapté pour relier électriquement le dispositif de pilotage 12 au module lumineux 11.

Le faisceau de connexion 13 comprend :
- un connecteur mâle 130 adapté pour être connecté au connecteur femelle 120 du dispositif de pilotage 12 de sorte à relier électriquement le dispositif de pilotage 12 au module lumineux 11 ;
- des fils de connexion 131.

Dans un mode de réalisation non limitatif le connecteur mâle 130 est clippé avec le connecteur femelle 120. Les fils de connexion 131 sont adaptés pour connecter le connecteur mâle 130 à une source d'alimentation électrique du véhicule automobile, au(x) module(s) lumineux 11 et à une unité de contrôle du véhicule automobile (non illustrée). Les fils de connexion 131 permettent ainsi au dispositif de pilotage 12 de piloter l'alimentation des sources lumineuses du module lumineux 11 en fonction de commandes de pilotage issues de l'unité de contrôle du véhicule automobile.

### • Boîtier 10

Le boîtier 10 est illustré à la figure 1.

Il est adapté pour :
- venir se loger dans un logement réservé dans le véhicule automobile ;
- recevoir le module lumineux 11 et le dispositif de pilotage 12 du dispositif lumineux 1.

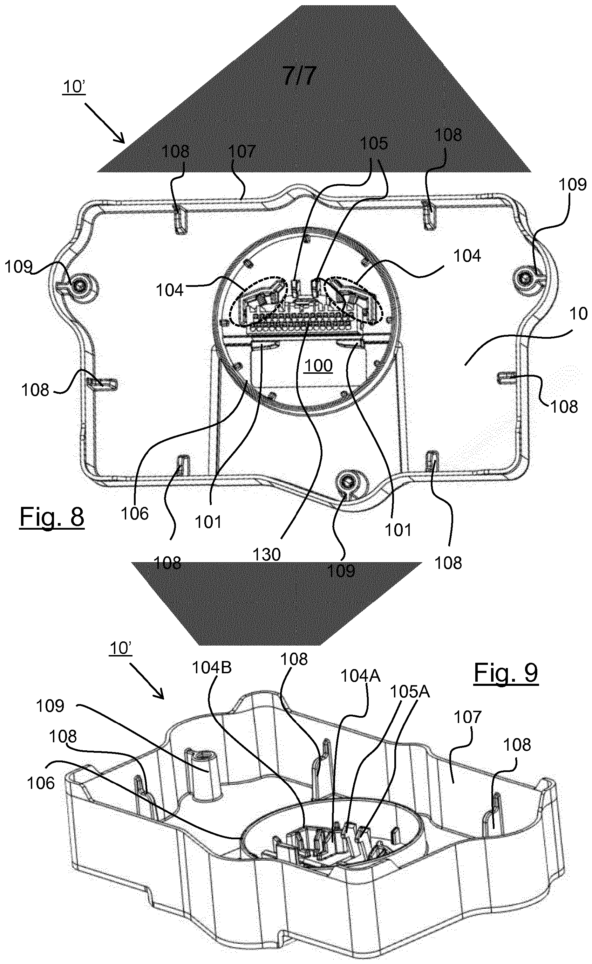

Le boîtier 10 est illustré selon un premier mode de réalisation non limitatif aux figures 2 à 7 et selon un deuxième mode de réalisation non limitatif aux figures 8 et 9.

Tel qu'illustré sur les figures 1 à 9, le boîtier 10 comprend une partie 10' adaptée pour la réception du dispositif de pilotage 12. Cette partie 10' est appelée également partie d'accueil 10' dans la suite de la description.

Dans un mode de réalisation non limitatif, la partie d'accueil 10' est réalisée dans le même matériau que le reste du boîtier 10 au cours d'une même opération de fabrication, par exemple une opération de moulage dans un mode de réalisation non limitatif.

Dans un mode de réalisation non limitatif illustré sur les figures 2 à 6 et 8-9, le boîtier 10 (en particulier la partie d'accueil 10') comprend :
- une collerette d'étanchéité secondaire 106 sensiblement centrée dans ladite partie d'accueil 10' ;
- un rebord 107 ;
- au moins un plot d'appui 108 ;
- au moins un fût de fixation 109.

La collerette d'étanchéité secondaire 106 est adaptée pour assurer l'étanchéité du dispositif de pilotage 12 avec la partie d'accueil 10' du boîtier 10. Cette collerette d'étanchéité secondaire 106 entoure l'orifice 100, le sous-orifice 100', le logement 103, les nervures 101 et le réseau de nervures 104.

Elle est adaptée pour s'emboîter autour de la collerette d'étanchéité primaire 1214 du dispositif de pilotage 12.

Tel qu'illustré sur la figure 3, le rebord 107 est adapté pour accueillir le dispositif de pilotage 12. Il entoure ainsi le dispositif de pilotage 12 lorsque ce dernier est positionné sur la partie d'accueil 10'. Dans un mode de réalisation non limitatif, le rebord 107 est de forme sensiblement rectangulaire.

Ledit au moins un plot d'appui 108 est adapté pour recevoir et supporter le dispositif de pilotage 12. Dans l'exemple non limitatif illustré, il y a six plots d'appui 108.

Ledit au moins un fût de fixation 109 est adapté pour être en vis-à-vis avec un des ergots de fixation 1213 du corps principal 1210 du dissipateur thermique 121. Des moyens de fixation, tels que la tige filetée ou la vis, sont ainsi adaptés pour solidariser le dispositif de pilotage 12 avec la partie d'accueil 10' du boîtier 10 via ledit au moins un fût de fixation 109 et l'ergot de fixation 1213 associé. Dans l'exemple non limitatif illustré, il y a trois fûts de fixation 109.

Le boîtier 10 (en particulier la partie d'accueil 10') comprend en outre :
- un orifice 100 ;
- au moins deux nervures 101, 104.

L'orifice 100 est adapté pour le passage du faisceau de connexion 13 depuis l'intérieur vers l'extérieur du boîtier 10.

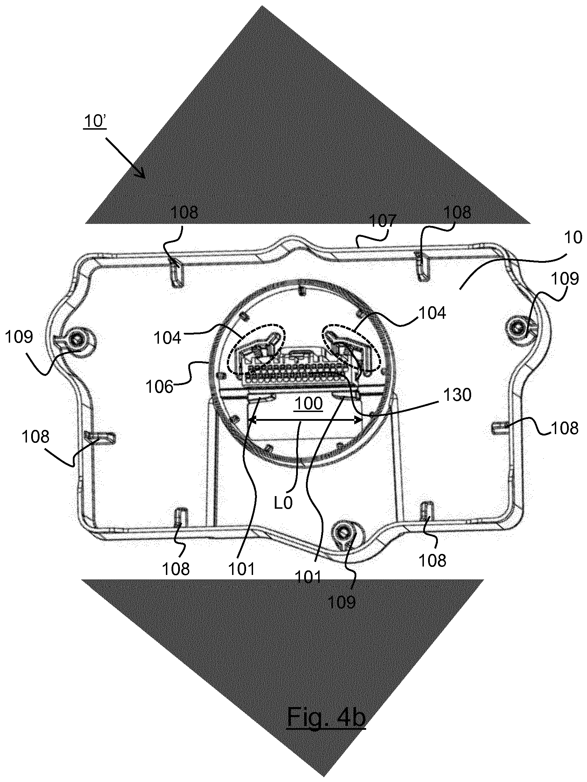

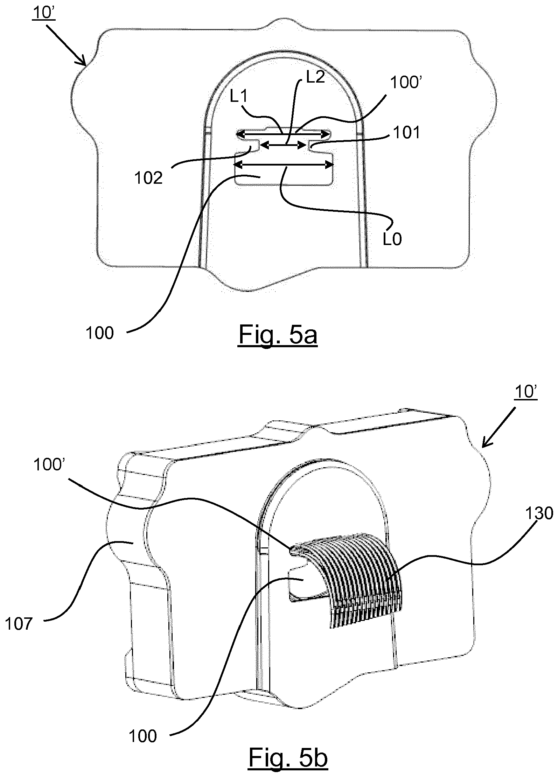

Tel qu'illustré sur la figure 4b ou 5a, l'orifice 100 a une largeur L0. Cette largeur L0 est sensiblement supérieure ou égale à la largeur L0' (illustrée sur la figure 2) du connecteur mâle 130 de sorte à permettre ledit passage du connecteur mâle dans l'orifice 100.

Lesdites au moins deux nervures 101, 104 définissent un logement 103 (illustré sur la figure 2) pour accueillir et bloquer ledit connecteur mâle 130 sur le boîtier 10.

Dans un mode de réalisation non limitatif illustré sur les figures 2, 4a, 5b, deux nervures 101 s'étendent dans l'orifice 100 et définissent un sous-orifice 100' pour le passage du faisceau de connexion 13, une fois le connecteur mâle 130 bloqué dans le logement 103. Les deux nervures 101 permettent de coincer les fils de connexion 131 dans ledit sous-orifice 101'.

Dans un mode de réalisation non limitatif, tel qu'illustré sur la figure 5a, le sous-orifice 100' est de largeur L1. La largeur L1 est sensiblement égale ou inférieure à la largeur L1' (illustrée sur la figure 2) du faisceau de connexion 13.

En outre, la largeur L1 du sous-orifice 100' est inférieure à la largeur L0' du connecteur mâle 130. De cette manière, le connecteur mâle 130 est bloqué par le sous-orifice 100' dans le logement 103, une fois le connecteur mâle 130 déplacé vers ledit sous-orifice 100'. Le connecteur mâle 130 est bloqué dans toutes les directions X, Y et Z par les deux nervures 101 et le réseau de nervures 104.

Tel qu'illustré sur la figure 5a, dans un mode de réalisation non limitatif, les deux nervures 101 s'étendent de part et d'autre de l'orifice 100 en définissant un espace L2 entre elles pour permettre le passage du faisceau de connexion 13 (en particulier des fils de connexion 131) depuis l'intérieur dudit boîtier 10 lors de montage dudit connecteur mâle 130 sur ledit boîtier 10. La largeur de cet espace L2 est inférieure :
- à la largeur L0 de l'orifice 100 ;
- à la largeur L1 du sous-orifice 100' ;
- à la largeur L1' du faisceau de connexion 13.

Ainsi, lors de l'assemblage, l'opérateur doit faire pivoter le faisceau de connexion 13 autour de son axe principal pour faire passer ledit faisceau de connexion à travers l'espace L2 en direction du sous-orifice 100'. De cette manière, il est possible de venir positionner le connecteur mâle 130 dans le logement 103.

On notera que les nervures 101 sont configurées de sorte à être suffisamment petites pour laisser passer le faisceau de connexion 13, et sont configurées de sorte à être suffisamment grandes pour leur fabrication, par un procédé d'injection dans un exemple non limitatif.

Tel qu'illustré sur les figures 2, 4a, 4b, 8 et 9, dans un mode de réalisation non limitatif, le boîtier 10 comprend un réseau de nervures 104, en retrait de l'orifice 100 adapté pour définir avec lesdites deux nervures 101 dans l'orifice 100 ledit logement 103 de réception dudit connecteur mâle 13.

Dans un mode de réalisation non limitatif, le réseau de nervures 104 comprend :
- des nervures primaires 104A définissant le logement 103 ;
- au moins une nervure secondaire 104B adaptée pour solidariser le reste du réseau de nervures 104 au boîtier 10.

Tel qu'illustré sur la figure 4a, le réseau de nervures 104 est ainsi divisé en deux sous-réseaux de nervures comprenant respectivement au moins une nervure primaire 104A et une nervure secondaire 104B associée. Chaque sous-réseau de nervures est situé respectivement en regard de chaque nervure 101, le sous-réseau de nervures et la nervure 101 étant disposés de chaque côté du sous-orifice 100'.

Dans un mode de réalisation non limitatif illustré à la figure 4b, le réseau de nervures comprend six nervures primaires 104A et deux nervures secondaires 104B. Trois nervures primaires 104A s'étendent à partir d'une nervure secondaire 104B. Ainsi, dans l'exemple non limitatif illustré, chaque sous-réseau de nervures comprend trois nervures primaires 104A et une nervure secondaire 104B.

Dans un mode de réalisation non limitatif illustré à la figure 4b, les nervures primaires 104A définissant ledit logement 103 sont orientées dans différentes directions de sorte à bloquer ledit connecteur mâle 130 dans lesdites directions.

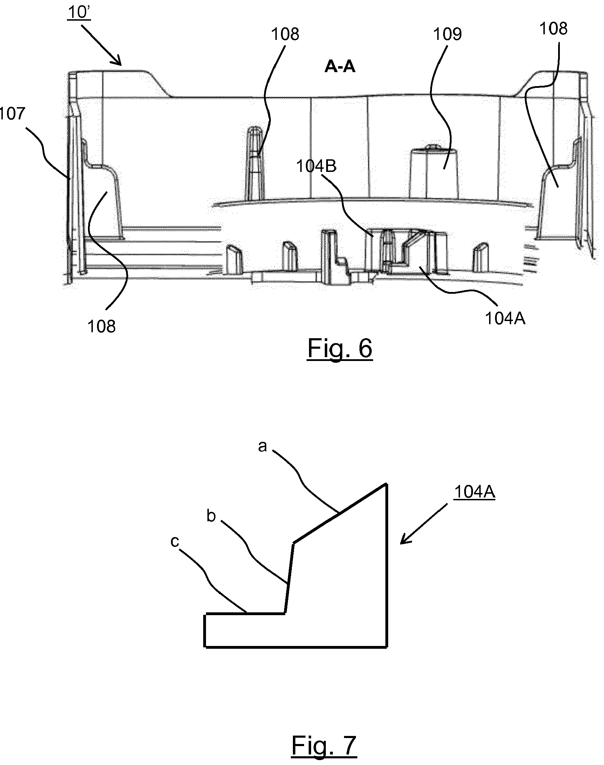

Dans un mode de réalisation illustré sur les figures 6 et 7, chaque nervure primaire 104A définissant ledit logement 103 comprend un profil en escalier avec :
- une pente oblique a pour forcer le centrage dudit connecteur mâle 130 dans ledit logement 103 ;
- un ressaut b pour bloquer en butée ledit connecteur mâle 130 ;
- un plateau c servant d'appui pour ledit connecteur mâle 130 sur ledit boîtier 10.

Il est ainsi possible de garantir une bonne tenue mécanique du connecteur mâle 130 dans le logement 103.

On notera que les nervures primaires 104A ont une forme qui s'adapte à la forme spécifique du connecteur mâle 130.

Les nervures secondaires 104B permettent d'avoir une bonne résistance mécanique.

Dans le deuxième mode de réalisation non limitatif illustré sur les figures 8 et 9 du boîtier 10 (en particulier sa partie d'accueil 10'), le boîtier 10 comprend en outre au moins un clip de maintien 105 pour maintenir le faisceau de connexion 13 en position dans le logement 103. Dans l'exemple non limitatif illustré, il y a deux clips de maintien 105. Les clips de maintien 105 sont disposés entre les deux sous-réseaux de nervures décrites précédemment.

Dans un mode de réalisation non limitatif illustré à la figure 9, chaque clip de maintien 105 comprend une tête 105A adaptée pour reposer sur le connecteur mâle 130 du faisceau de connexion 13 de sorte à le maintenir en position. Les clips de maintien 105 permettent un meilleur maintien en position selon la direction Z du faisceau de connexion 13.

### • Montage du faisceau de connexion 13 dans le boîtier 10

Dans une première étape de montage, l'opérateur vient amener le faisceau de connexion 13 dans l'orifice 100 par l'intérieur du boîtier 10. Une partie des fils de connexion 131 du faisceau de connexion 13 dépasse de l'orifice 100 de sorte à pouvoir engager, dans une seconde étape de montage, ledit faisceau de connexion 13 dans le sous-orifice 100' délimité par les deux nervures 101. Le connecteur mâle 130 du faisceau de connexion 13 est ensuite placé par l'opérateur dans le logement 103. L'opérateur appuie sur le connecteur mâle 130 pour qu'il se bloque dans le logement 130. Le connecteur mâle 130 est ainsi maintenu dans ledit logement 130 grâce aux nervures 101, 104. L'opérateur peut ainsi lâcher le faisceau de connexion 13.

Cela libère les mains de l'opérateur. L'opérateur n'a plus besoin de maintenir manuellement le faisceau de connexion 13. Ce dernier ne peut plus bouger librement. Dans cette position, les fils de connexion 131 sortent du sous-orifice 100' à l'intérieur 1A (intérieur illustré sur la figure 1) du boîtier 10, tel qu'illustré sur la figure 5b. Dans une étape suivante, il est alors possible à l'opérateur avec une de ses mains de plaquer le dispositif de pilotage 12 sur le boîtier 10, en particulier dans la partie d'accueil 10' dudit boîtier 10, pour connecter son connecteur femelle 120 au connecteur mâle 130 du faisceau de connexion 13, et avec son autre main de fixer en même temps le dispositif de pilotage 12 sur le boîtier 10, en particulier dans la partie d'accueil 10' avec des vis dans les ergots de fixation 1213 et les fûts de fixation 109 associés.

Bien entendu, la description de l'invention n'est pas limitée aux modes de réalisation décrits ci-dessus.

Ainsi, dans un autre mode de réalisation non limitatif, le réseau de nervures 104 peut comprendre une unique nervure secondaire 104B qui solidarise l'ensemble des nervures primaires 104A au boîtier 10 (ici les six nervures primaires 104A).

Ainsi, dans un autre mode de réalisation non limitatif, le dispositif lumineux 1 peut comporter plus de deux modules lumineux 11.

Ainsi, l'invention décrite présente notamment les avantages suivants :
- elle améliore l'ergonomie pour l'opérateur lors de l'assemblage du dispositif de pilotage 12 sur le boîtier 10. Il n'est ainsi pas nécessaire audit opérateur de tenir le faisceau de connexion 13 lors de cet assemblage ;
- elle permet d'augmenter la productivité de l'opérateur lors de l'assemblage du dispositif de pilotage 12 sur le boîtier 10 ;
- elle permet un accès facile au dispositif de pilotage 12 ;
- elle facilite le démontage du dispositif de pilotage 12, lorsque ledit dispositif de pilotage 12 doit être changé.

## Revendications

1. Dispositif lumineux (1) pour véhicule automobile, ledit dispositif lumineux (1) comprenant :
- un boîtier (10) ;
- un module lumineux (11) disposé à l'intérieur dudit boîtier (10) ;
- un dispositif de pilotage (12) adapté pour piloter l'alimentation électrique dudit module lumineux (11) comportant un connecteur femelle (120) monté à l'extérieur dudit boîtier (10) ;
- un faisceau de connexion (13) relié audit module lumineux (11) et comportant un connecteur mâle (130) adapté pour être connecté audit connecteur femelle (120) dudit dispositif de pilotage (12) de sorte à relier électriquement ledit dispositif de pilotage (12) audit module lumineux (11),
**caractérisé en ce que** ledit boîtier (10) comporte :
- un orifice (100) pour le passage dudit faisceau de connexion (13) depuis l'intérieur vers l'extérieur dudit boîtier (10) ; et
- au moins deux nervures (101, 104) définissant un logement (103) pour accueillir et bloquer ledit connecteur mâle (130) sur ledit boîtier (10).

2. Dispositif lumineux (1) selon la revendication 1, dans lequel lesdites au moins deux nervures (101) s'étendent dans ledit orifice (100) et définissent un sous-orifice (100') pour le passage dudit faisceau de connexion (13) une fois ledit connecteur mâle (130) bloqué dans le logement (103).

3. Dispositif lumineux (1) selon la revendication 1 ou la revendication 2, dans lequel ledit sous-orifice (100') est de largeur (L1) sensiblement égale ou inférieure à la largeur (L1') dudit faisceau de connexion (13).

4. Dispositif lumineux (1) selon l'une quelconque des revendications 1 à 3, dans lequel lesdites au moins deux nervures (101) s'étendent de part et d'autre dudit orifice (100) en définissant un espace (L2) entre elles pour permettre le passage du faisceau de connexion (13) depuis l'intérieur dudit boîtier (10) lors de montage dudit connecteur mâle (130) sur ledit boîtier (10).

5. Dispositif lumineux (1) selon l'une quelconque des revendications 1 à 4, dans lequel ledit boîtier (10) comprend un réseau de nervures (104), en retrait dudit orifice (100), adapté pour définir avec lesdites au moins deux nervures (101) dans l'orifice (100) ledit logement (103) de réception dudit connecteur mâle (130).

6. Dispositif lumineux (1) selon la revendication 5, dans lequel ledit réseau de nervures (104) comprend :
- des nervures primaires (104A) définissant ledit logement (103) ;
- au moins une nervure secondaire (104B) adaptée pour solidariser le reste du réseau de nervures (104) au boîtier (10).

7. Dispositif lumineux (1) selon la revendication 6, dans lequel lesdites nervures primaires (104A) sont orientées dans différentes directions de sorte à bloquer ledit connecteur mâle (130) dans lesdites directions.

8. Dispositif lumineux (1) selon la revendication 6 ou la revendication 7, dans lequel chaque nervure primaire (104A) comprend un profil en escalier avec :
- une pente oblique (a) pour forcer le centrage dudit connecteur mâle (130) dans ledit logement (103) ;
- un ressaut (b) pour bloquer en butée ledit connecteur mâle (130) ;
- un plateau (c) servant d'appui pour ledit connecteur mâle (130) sur ledit boîtier (10).

9. Dispositif lumineux (1) selon l'une quelconque des revendications 1 à 8, dans lequel ledit boîtier (10) comprend en outre au moins un clip de maintien (105) adapté pour maintenir le faisceau de connexion (13) en position.

10. Dispositif lumineux (1) selon l'une quelconque des revendications 1 à 9, dans lequel ledit dispositif de pilotage (12) est plaqué sur ledit boîtier (10) pour connecter ledit connecteur femelle (120) audit connecteur mâle (130).

11. Dispositif lumineux (1) selon l'une quelconque des revendications précédentes 1 à 10, dans lequel une source lumineuse (11) est une source lumineuse à semi-conducteur.

12. Dispositif lumineux (1) selon la revendication 11, dans lequel ladite source lumineuse à semi-conducteur (11) fait partie d'une diode électroluminescente.

13. Dispositif lumineux (1) selon l'une quelconque des revendications 1 à 12, dans lequel ledit dispositif lumineux (1) est un projecteur.
